(19)

Europäisches Patentamt
European Patent Office
Office européen des brevets

(11) **EP 2 508 469 A1**

(12) **EUROPEAN PATENT APPLICATION**

(43) Date of publication:
**10.10.2012 Bulletin 2012/41**

(51) Int Cl.:
***B81C 1/00*** *(2006.01)*

(21) Application number: **11161233.9**

(22) Date of filing: **05.04.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **The Provost, Fellows, Foundation
Scholars, and the
other Members of Board, of the College of the
Holy
and Undivided Trinity of Queen Elizabeth
Dublin 2 (IE)**

(72) Inventors:
• **Krstic, Vojislav
D2, Dublin 2 (IE)**
• **Hernandez, Jose Manuel Caridad
D2, Dublin 2 (IE)**

(74) Representative: **Lucey, Michael
PURDYLUCEY
Intellectual Property
Suite 138-139
The Chapel Building
Mary's Abbey
Dublin 7 (IE)**

(54) **Three-dimensional nano-sculptured structures of high surface-mobility materials and methods of making same**

(57) A method for growing sculptured 3D nano-structures of high-surface mobility materials on an arbitrary substrate, the method comprising the steps of: depositing layers of low and high thermal conductive materials and growing the nano-structures thereon; while maintaining low and constant temperature along the structure during growth of the 3D nano-structures.

Figure 2

EP 2 508 469 A1

**Description**

**Field of the Invention**

The invention relates to a method for growing materials. In particular the invention relates to a method for growing nanoscaled three-dimensional sculptured structures made of high surface-mobility materials, and devices comprising such structures.

**Background to the Invention**

Three-dimensional (3D) sculptured nano-structures can be designed and tailored by Physical Vapour Deposition (PVD) of materials, such as using Glancing Angle Deposition (GLAD). The choice of materials for physical vapour deposition remains a limiting factor. Some metals (such as nickel (Ni) or copper (Cu)) are not easy to engineer on the nano-scale due to their high surface mobility, which is often manifested in agglomeration and deformity of the nano-structures. An example of this is presented by Elias et al. ("Fabrication of Helically Perforated Gold, Nickel, and Polystyrene Thin Films", Journal of Microelectromechanical Systems, (2204) Vol. 13(5), pp. 808-813) where the authors state that to prevent nucleation sites from coalescing into a solid film (agglomerated nano-structures), only materials with sufficiently limited surface diffusion lengths may be used in the GLAD process, such as Si, $SiO_2$, Ti, $TiO_2$, and $Al_2O_3$. The authors also state that many metals such as copper and nickel make poor choices due to their high surface mobility.

However, the possibility of engineering 3D sculptured nano-structures and nano-devices made from these materials is highly desirable due to the multiple potential applications in which they can be used such as magnetic recording and storage, chiral sensors, electronic and optical devices or high efficient energy harvesting devices. In US Patent Publication No. US 2010/0147371, the applicants have described energy harvesting devices using nano-helix structures, possibly composed of silicon and high electrical conductivity materials, with an electrical conductance measurement of $\sigma > 1\ \Omega^{-1}m^{-1}$, such as metals.

A problem when growing PVD 3D nano-sculptured structures with high surface diffusion materials is the control of the mobility of the incoming atoms when they attach to the structure surface. This mobility highly depends on the growth temperature, which is not constant but increases strongly during the deposition (typically $\Delta T > 200°C$).

To reduce the surface mobility of incoming atoms during GLAD, attempts have been made by some to cool down the substrate during growth of sculptured nano-structures. However, the solution of cooling down the substrate leads to formation of an undesirable strong temperature gradient during the growth phase between the top and bottom parts of the substrate and the top of the nano-structures during growth. The strong temperature gradient prevents growth of structurally well-defined sculptured nano-structures due to increased un-correlated diffusion of atoms along the structure-surface during growth. Furthermore, when cooling down the substrate, higher energy phonons are strongly suppressed, decreasing the thermal conductivity of this material (phonons are the main heat carriers in insulators and semiconductors, i.e., the common industrial substrate materials). Thus, despite of the low temperature of the substrate, heat transfer from the nano-structures to the substrate is highly reduced. Therefore, the heat is not transferred to the substrate but kept in the nano-structures, raising the temperature of the nano-structures unfavourably. Consequently, surface diffusion of incoming atoms is effectively not reduced within the structure and 3D sculptured nano-structures are deformed and agglomerated. Thus, if the thermal conductivity of the substrate is not high enough (as occurs in common substrates like silicon oxide ($SiO_2$)), cooling down the substrate will not provide a viable way to grow the nano-structures.

In addition, the cool-down of a whole wafer at an industrial scale has several technological difficulties and increases the costs of the fabrication process.

There is therefore a need to provide a method to produce 3D sculptured nano-structures of high surface diffusion materials and devices comprising such structures that overcome the above mentioned problems.

**Summary of the Invention**

According to the present invention there is provided, as set out in the appended claims, a method of growing 3D sculptured nano-structures on a substrate comprising the steps of:

depositing a layer of high thermal conductive material on a substrate; and
growing nano-structures on the layer of high thermal conductive material, wherein the high thermal conductive material provides a heat dissipating path to allow for growth of sculptured nano-structures.

In one embodiment of the present invention, the method may further comprise the step of depositing a layer of readily-soluble low thermal conductive material on the layer of high thermal conductive material. The deposition of a readily-soluble, low thermal conductive layer is advantageous in that where it is not desired to have nano-structures grown on the high thermal conductive material; the nano-structures are grown on the readily-soluble low thermal conductive layer. The removal of the low thermal conductive layer after growth of the 3D sculptured nano-structures also removes the unwanted nano-structures. In addition, the low thermal conductive layer allows a more efficient heat management and a deliberate positioning of the structures on the substrate.

The present invention provides a method for growing regularly shaped and spaced apart 3D sculptured nano-structures on a substrate, while maintaining a low and constant temperature along the structures during the growth phase. The method employs the use of both high thermal conductive metals and low thermal conductive materials to ensure that the temperature of the sculpted nano-structures is maintained at a low and constant level during growth. The combination of both layers allow the creation of arrays of regular shaped, free-standing, 3D sculptured nano-structures made from metals and high surface mobility materials. In essence, the combination of layers, and in particular the high thermal conductive material selected, acts as a thermal management system. The heat generated during the deposition or growth stage of the process is dissipated through the high thermal conductive material and into the substrate. The substrate acts a heat sink or an equilibrator, maintaining the temperature at a low and constant level during growth. The thermal management takes away the thermal energy from the growth area so that more control of the atoms is obtained to allow for better sculpting of the nano-structures.

In one embodiment of the present invention, the method may further comprise the step of controlling the deposition of said layer of high thermal conductive material. The step of controlling provides a plurality of spaced apart dots of high thermal conductive material on top of said layer of high thermal conductive material forming said pre-patterned substrate, or a plurality of spaced apart dots of arbitrary material on the substrate and on top of these dots and substrate, a layer of high thermal conductive material forming said pre-patterned substrate.

In one embodiment of the present invention, the method may comprise the use of objects other than dots, such as any kind of spheres (spherical particles), pillars or cubes for the step of controlling the deposition.

In one embodiment of the present invention, the high thermal conductive material may be selected from the group of high thermal conductive metals (e.g. silver, gold, copper) and other non-metallic and molecular high thermal conductive materials such as diamond, graphene and related materials having a thermal conductance of $K > 10\ Wm^{-1}K^{-1}$.

In one embodiment of the present invention, the layer of low thermal conductive material may be selected from the group of lithographical resist with a thermal conductance of $\kappa < 1\ Wm^{-1}K^{-1}$, such as poly(methyl methacrylate).

In one embodiment of the present invention, the method may further comprise a step of removing the layer of low thermal conductive material. The step of removing the layer of low thermal conductive material may be performed by dipping the substrate in an organic solvent selected from the group consisting of acetone or any other commercially available solvent used for lithography resist.

In one embodiment of the present invention, the dots may have a height of between about 10nm to about 100nm, preferably between about 20nm and about 80nm, and ideally about 50nm.

In one embodiment of the present invention, the dots may have a diameter of between about 10nm to about 100nm, preferably between about 30nm and about 80nm, and ideally about 50nm.

In one embodiment of the present invention, the dot-array may have a pitch of between about 5$\mu$m to about 10nm, preferably between about 500nm and about 50nm, and ideally about 150nm.

In one embodiment of the present invention, said 3D nano-sculptured structures may be grown in a substantially vertical direction to said substrate.

In one embodiment of the present invention, said 3D sculptured nano-structures may be grown without any additional external cooling or heating. In a preferred embodiment, the 3D sculptured nano-structures may be grown at room temperature.

In one embodiment of the present invention, said nano-structures may have the form of a coil, a chevron, and vertical and slanted rods.

In one embodiment of the present invention, the substrate may comprise silicon and any types of dielectrics such as $SiO_2$, $MgO$, $Si_3N_4$, or AlTiC.

In another embodiment of the present invention, there is provided a device comprising sculptured nano-structures grown according to the method of the present invention.

In one embodiment of the present invention, the device is selected from the group comprising sensors, high efficiency energy harvesting devices, magnetic storage devices, nano-bit magnetic recording, chiral materials for electronic and optical applications, chiral sensors, photonic crystals, meta-material applications, micro- and nano-electromechanical systems, and micro- and nano-electrochemical systems. An example of such devices may be nano-inductors.

In a further embodiment of the present invention there is provided a surface suitable for growing 3D sculptured nano-structures, the surface may comprise a substrate; a pre- or post-patterned layer of high thermal conductive material; and a layer of low thermal conductive material applied onto the layer of high thermal conductive material.

The combination of a high thermal conductive layer overlaying the substrate and a readily soluble low thermal conductive layer on top of the high thermal conductive layer produces an efficient and rapid heat transfer from the desired nano-structures to the substrate and a thermal shield from areas of undesired growth of sculptured nano-structures. The rapid heat transfer allows the structures to grow with a constant temperature along the structures. The presence of the high and low thermally conductive layers and the rapid heat transfer to the substrate enables the creation of arrays of regularly shaped 3D sculptured nano-structures made from metals and high surface mobility materials which can be deliberately positioned on desired areas of the substrate.

In a further embodiment of the present invention, there is provided a system adapted for growing 3D sculptured nano-structures, the system may comprise a rotating substrate holder; at least one motor and at least one electronic circuit adapted to provide arbitrary rotational speeds, and a tilted angle control, characterised in that the motor is a continuous direct current motor which provides a continuous and smooth substrate rotation.

In one embodiment of the present invention, the system is adapted to be portable. In one embodiment, the system is further adapted to be retrofitted to any existing general purpose evaporator.

In the present invention, the term "room temperature" should be understood to mean a temperature of between 20°C (68°F) and 25°C (77°F).

In the present invention, the term "arbitrary rotational speeds" should be understood to mean a speed set by the person skilled in the art for depositing 3D sculptured nano-structures.

In the present invention, the term "chevron" should be understood to mean a pattern having a "V" or an inverted "V" shape forming a zigzag pattern.

In the present invention, the term "high electrical conductivity" should be understood to mean an electrical conductance measurement of $\sigma > 1 \ \Omega^{-1}m^{-1}$

In the present invention, the term "high thermal" should be understood to mean a thermal conductance measurement of $K > 10 \ Wm^{-1}K^{-1}$.

In the present invention, the term "low thermal" should be understood to mean a thermal conductance measurement of $K < 1 \ Wm^{-1}K^{-1}$.

## Brief Description of the Drawings

The invention will be more clearly understood from the following description of an embodiment thereof, given by way of example only, with reference to the accompanying drawings, in which:-

Figure 1 illustrates the GLAD scheme used in the method of the present invention;

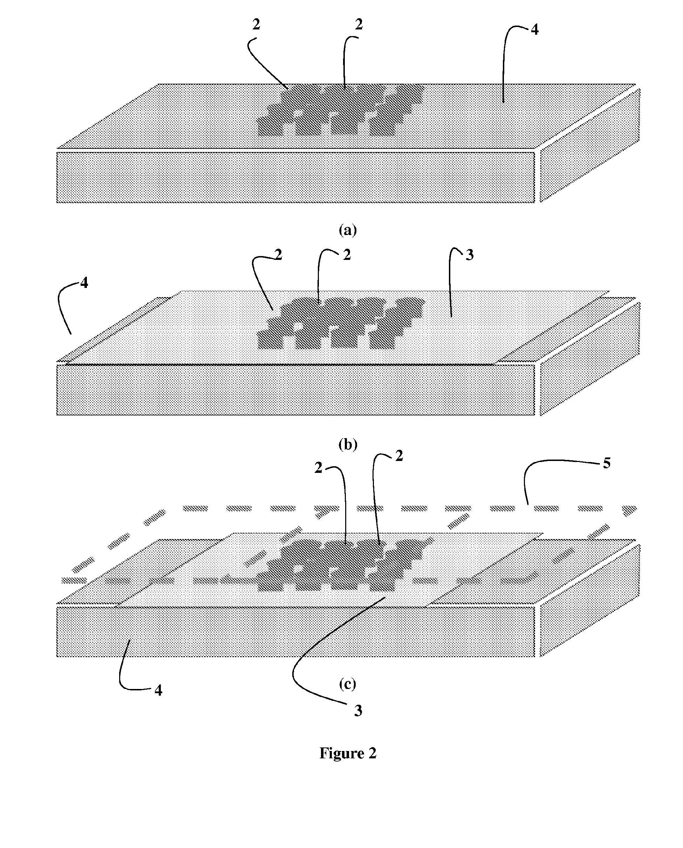

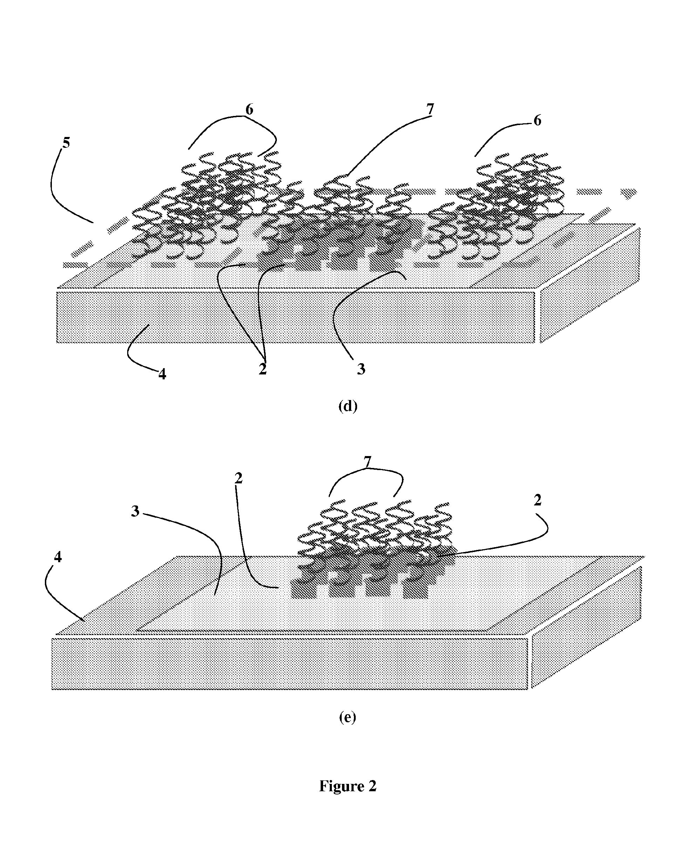

Figure 2 illustrates a schematic diagram explaining a method of growing nano-structures of the present invention, where (a) illustrates growth of an equally spaced array of a plurality of dots, (b) illustrates deposition of a thin layer of a high thermal conductivity material, (c) illustrates covering the substrate areas with low thermal conductive material (e.g. poly(methyl methacrylate) (PMMA)) where growth of nano-structures is not desirous, (d) illustrates growth of the desired nano-structures on the plurality of dots and undesired structures on poly(methyl methacrylate), and (e) illustrates removal of the covering with nano-structures thereon to reveal the desired nano-structures;

Figure 3 illustrates a scanning electron microscope (SEM) of samples grown using the methods of the prior art which form agglomerated nano-structures having irregular shapes and defining a porous thin film as the structures are touching each other;

Figure 4 illustrates a scanning electron microscope (SEM) of samples of nano-structures grown using the method as illustrated in Figure 2;

Figure 5 illustrates a comparison between (left) a nickel thin layer produced by PVD on a $SiO_2$ substrate and (right) an array of nickel nano-coils (black area) produced by the method of the present invention on a $SiO_2$ substrate;

Figure 6 illustrates a system design of one embodiment the present invention where (a) is a font view showing the rotating substrate holder inserted into an evaporator; (b) is a rear view showing two motors and electronic circuits; and (c) a side view showing the titling angle control; and

Figure 7 illustrates (a) a graph representing the steady state operation of the motor illustrated in Figure 6(b); and (b) a circuit which accomplishes a low potential drop converted into rotational motion (*Vb*) and high current (*I*) for creating high-quality 3D nano-structures.

## Detailed Description of the Drawings

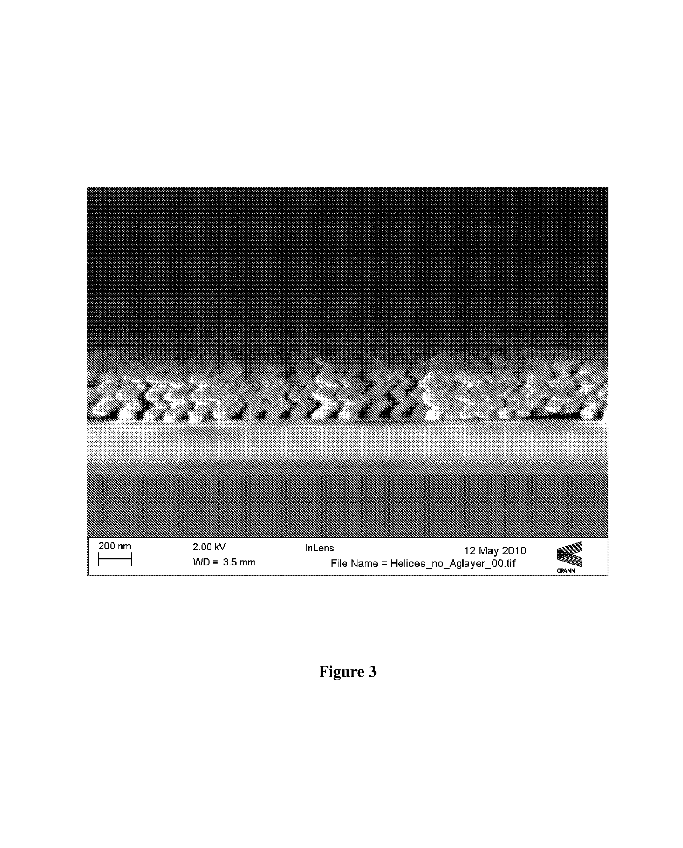

The invention involves growing 3D sculptured nano-structures on a layer consisting of a high thermal conductivity material (e.g. silver (Ag)) acting as a fast heat transport material and heat sink in combination with a readily-soluble, low thermal conductive thin layer of poly(methyl methacrylate) (PMMA) acting as a heat and matter shield covering the substrate areas where no structures are desired. The choice of materials for 3D sculptured nano-structures using PVD/ GLAD remains a limiting factor. Some metals (such as Ni or Cu) are not easy to engineer on the nano-scale due to their high surface mobility, which is often manifested in agglomeration and deformity of the nano-structures (see Figure 3).

The problem when growing PVD 3D nano-structures with high surface diffusion materials is the control of the mobility of the incoming atoms when they attach to the structure surface. This mobility greatly depends on the growth temperature, which is not constant but increases strongly during the deposition.

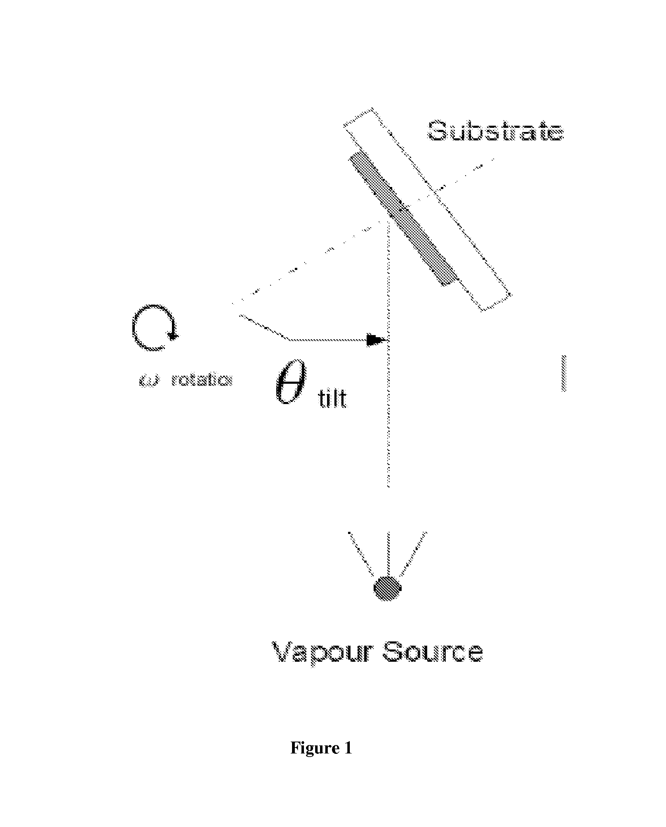

One means of depositing the incoming atoms is by Glancing Angle Deposition (GLAD), as illustrated in Figure 1. GLAD is a physical vapour deposition process that is well-known in the art. In this process, the substrate is normally oriented at an angle of tilt $\theta$ with respect to the vapour source. The design of the nano-structures can be tailored by controlling the deposition rate r and controlling the motion of the substrate which is achieved by modifying the rotation speed $\omega$ and the tilted angle $\theta$.

Referring now to Figure 2, there is illustrated in a schematic diagram a method of the present invention demonstrating how regular 3D sculptured nano-structures of high surface diffusion materials and metals can be created on desired places of arbitrary substrates. The method consists of the following steps:

1.

(a) Growth of an equally spaced array of ~50nm height dots 2 are made from a high thermal conductive metal (*e.g.* Ag) on an area where the nano-structures will be placed (Figure 2a). Dots 2 are the starting point from where the nano-structures will grow.

(b) A thin layer (~50nm) of a high thermal conductive material (*e.g.* Ag) 3 is deposited on the substrate 4 and covering the spaced array of dots 2 (Figure 2b). This layer 3 acts as a fast heat-transport material from the growing structures to the substrate. The layer of high thermal conductive material 3 acts as a thermal management system, transporting heat created during the deposition process away from the structures and dissipating heat into the substrate.

2. Where it is not desirous for nano-structures to grow on the substrate area, that area is covered with a low thermal conductive and readily-soluble material 5 such as PMMA. This layer 5 allows the removal of unwanted nano-structures 6 from regions of the substrate 4 where the growth of nano-structures is not desired. This layer of PMMA 5 also minimises heat transfer from the incoming flux of metal atoms to the substrate 4 in those undesired regions. Thus, these regions do not contribute to heating the substrate 4 and do not increase the deposition temperature. The PMMA thin layer 5 is created by coating, spinning and baking liquid PMMA-solution on the substrate 4. Although initially the PMMA layer 5 covers the equally spaced array of dots 2, it is removed by EBL exposure to expose the dots 2 (Figure 2c).

3. Growth of the desired nano-structures 7 by GLAD (Figure 2d). The nano-structures 7 can be engineered to a desired shape, for example a coil, a chevron (zigzag), or slanted structure, or rods, by rotating the substrate at speed $\omega$, through an angle of tilt $\theta$ with respect to the vapour source or maintaining the substrate 4 in one position.

4. Removal of the PMMA 5 (and any structures 6 which have grown on top) by inserting the sample in acetone (Figure 2e). As indicated in step 2 above, the PMMA layer 5 will have irregular nano-structure growths 6 on areas where such structures are not wanted. The removal of the overlying layer of PMMA 5 also rids the substrate 4 of undesired agglomerated nano-structures 6 leaving a substrate 4 having a set pattern of regularly shaped, freestanding and uniform 3D sculptured nano-structures 7 grown thereon.

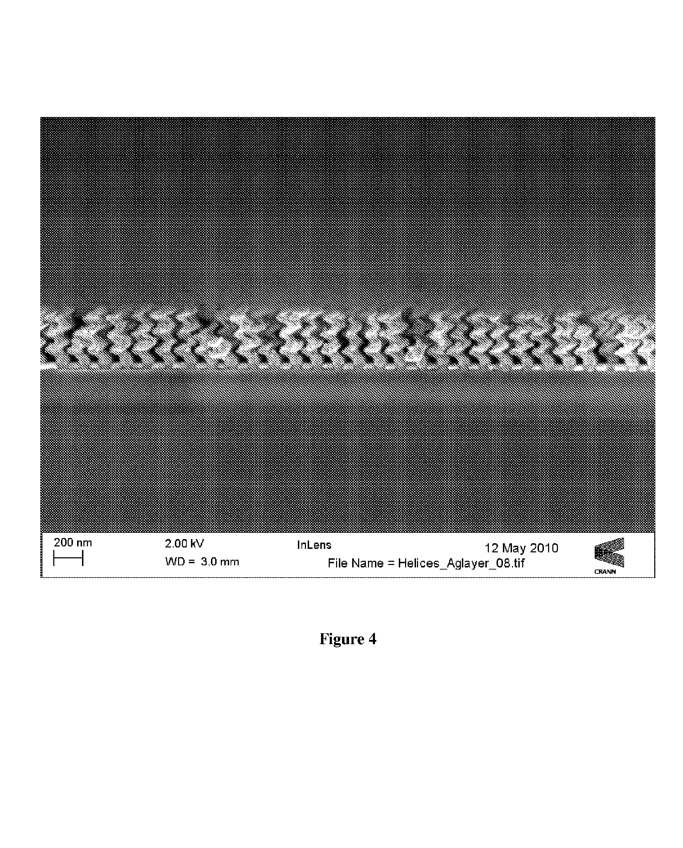

Referring now in detail to Figures 3 and 4, there is illustrated two scanning electron microscope (SEM) micrographs of nano-structures grown using Ni to form nano-helices. To prove the effects of combining a layer from a high thermal conductive material (*e.g.* Ag) and a low conductive material (*e.g.* PMMA), two samples of Ni nano-helices were grown: one without any of the Ag and PMMA layers (Figure 3) and one with both the Ag spaced apart dots plus additional layer of Ag and PMMA layers (Figure 4). Figure 3 illustrates nano-structures grown by the methods of the prior art, while Figure 4 illustrates sculptured 3D nano-structures grown by a method of the present invention.

Figure 3 is a SEM micrograph showing samples of Ni nano-structures grown without Ag and PMMA layers. The nano-structures are agglomerated and the shape is very irregular. During the deposition steps, the substrate will be heated up very quickly due to the incoming flux of Ni atoms. Consequently, the temperature of the nano-structures will be increasing considerably during the deposition and their shape will begin to deteriorate rapidly. Rather than an array of isolated helices, this picture shows a porous thin film, with the structures touching each other. The nano-structures manifest themselves as an agglomeration with severe structural deformities.

Figure 4 is a SEM micrograph showing samples of Ni nano-structures grown on a substrate with both a high thermal conductive Ag layer (including an array of spaced apart Ag dots) and a low thermal conductive PMMA layer. As demonstrated, the Ni nano-structures are highly regularly shaped and spaced apart so that they do not touch each other. This is unlike those nano-structures presented in Figure 3. By using the method of the present invention, it is possible to achieve regularly shaped and spaced apart 3D sculptured nano-structures grown on any substrate. The regular shapes and spaced apart sculptured 3D structures are achieved due to the presence of the low and the high thermal conductive layers. In this case the high thermal conductive layer is a plurality of spaced apart dots of Ag overlaid with a further layer of Ag. The substrate only receives heat from the area where the desired structures grow (this area is small in comparison with the substrate and thin film volume), which maintains the structures during the growth phase with a low and constant temperature along the sculptured structures. None of the prior art methods provide structures with low and constant temperatures along the sculptured nano-structures during the growth phase. As stated above, the PMMA layer also allows the elimination of the nanostructures deposited on undesired areas of the substrate. Furthermore, the deposition of the high surface mobile materials is carried out without any additional external cooling or heating at room temperature.

As stated above, the prior art PVD methods of growing 3D sculptured nano-structures of high surface diffusion (mobility) metals causes agglomeration and deformity in the nano-structures. The growth temperature of the prior art PVD methods are strongly increasing during growth.

PVD growth is performed in high vacuum conditions, thus, the only way to expel the heat of the nano-structure in *situ* is through the substrate. As demonstrated here, the advantages of the method of the present invention is that heat transfer from the structures to the substrate is favoured by inserting a thin layer of a high conductive material between the nano-structures and the substrate. The high conductive material acts as a fast heat transport material and as a heat-sink during the deposition, providing a thermal management system. By placing a low thermal conductive layer outside of the areas on the substrate upon which nano-structures are desired, heat coming from deposited atoms on those areas do not warm up the substrate. As the low thermal conductive layer is also readily soluble, it allows for deliberate and precise positioning of the nano-structures on the substrate.

The provided solution to the problem of dissipating heat efficiently and successfully not only allows the fabrication of 3D sculptured nano-structures from desirable high surface mobility materials, but also improves the shape and quality of samples made from other materials.

The combination of a high thermal conductive layer and a readily-soluble low thermal conductive layer, produce a fast heat transfer from the desired nano-structures to the substrate, which maintains a low and constant temperature along the nano-structures during growth. Both layers allow the creation of arrays of regular shaped 3D sculptured nano-structures made from high surface mobility materials which can be deliberately positioned on desired areas of the substrate.

These structures had never been fabricated previously and such attempts reported poor quality samples. The broad number of applications in which they can be used is mainly determined by the novel properties that these nano-structures present. Such applications include sensors, high efficiency energy harvesting devices, magnetic storage devices, nano-bit magnetic recording, chiral materials for electronic and optical applications, chiral sensors, photonic crystals, meta-material applications, micro- and nano-electromechanical systems and micro- and nano-electrochemical systems.

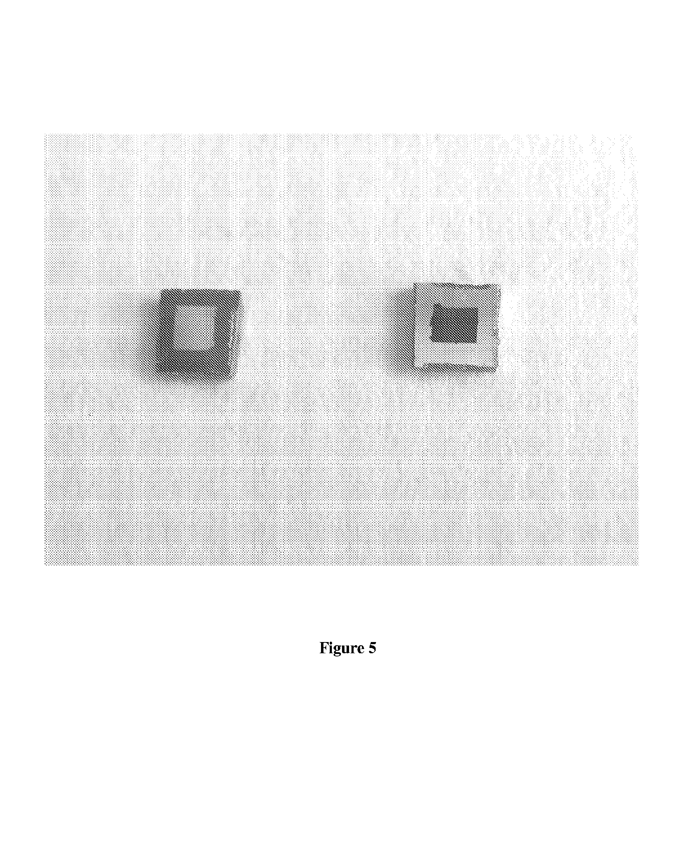

With reference now to Figure 5, there is presented on the left a sample of an evaporated Ni thin layer (~80nm) on top of silicon oxide ($SiO_2$) substrate. The thin layer has the characteristic Ni colour, which is a shiny grey. On the right hand side of Figure 5, there is a sample of an evaporated array of sculptured Ni nano-helices (matt black area) grown on a thin layer of Ag. The nano-helices were produced by the method of the present invention described above. By comparing both samples, it can be easily seen that a genuine property of the nano-helices array is that less light is specularly reflected in the sample on the right produced by the method of the present invention. This demonstrates that the nano-structures absorb most incident visible light.

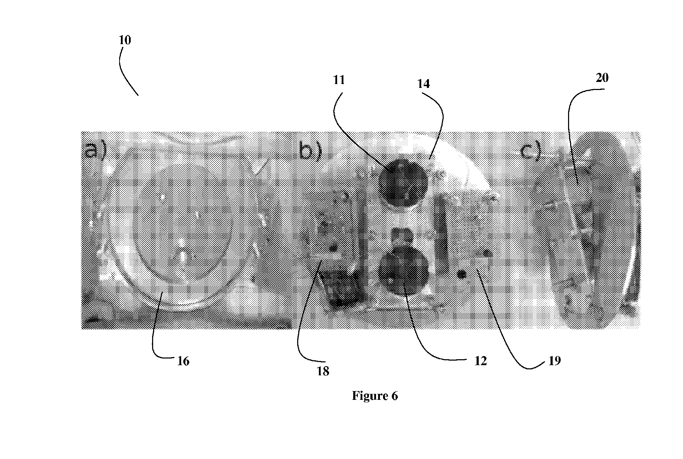

Now referring to Figure 6, there is illustrated a controlled substrate motion system 10 which can be placed inside a general purpose evaporator for growing the nano-sculptured structures of the present invention. Despite the availability of complex and dedicated GLAD deposition systems, the system provided by the present invention is portable, low cost and can be retro-fitted to any existing evaporator. The system consists of an electronically controlled direct current (DC) motor 11,12 fixed on mechanical pieces 14 which are mounted on a wafer holder 16 provided by the evaporator (see Figure 6(a)-(c)).

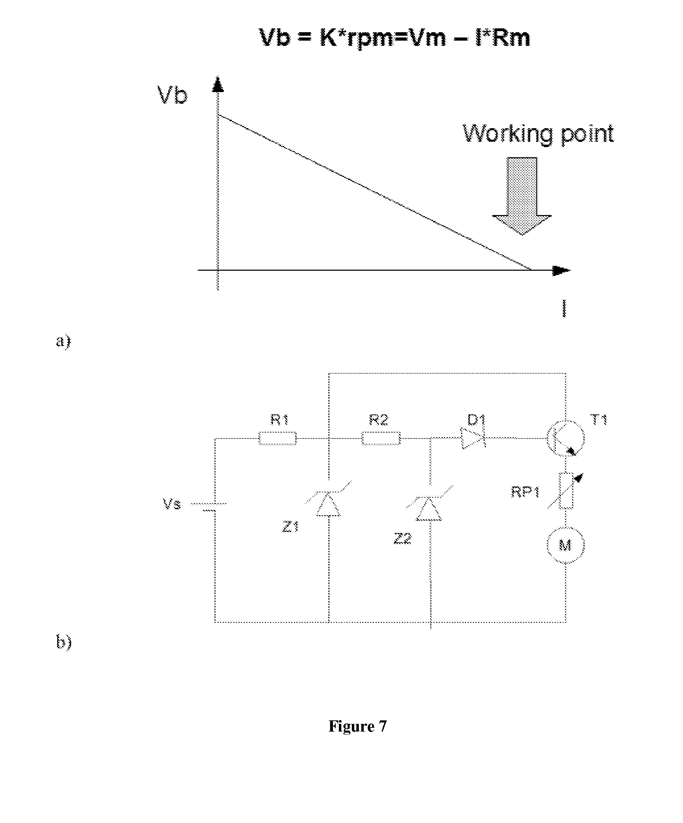

The available dedicated GLAD deposition systems use stepper motors, which provide rough, non-uniform rotation at low rotational speeds. Uniform, continuous rotation at low rotational speed is an essential requirement to grow nano-structures such as coils with a non-disrupted, smooth surface. The present invention utilises DC motors 11,12 (Figure 6(b)) rather than stepper motors. DC motors provide a continuous and smooth substrate rotation required to grow structures at the nano scale with non-disruptive, smooth surface. However, to tune the desired substrate rotation speed with a DC motor is more complicated than with the commonly used stepper motors. In the present embodiment, the substrate rotation speed provided by the DC motor 11,12 is controlled by an analog electronic circuit 18,19 (Figure 6(b) and Figure 7). Applying a voltage *Vm* to the DC motor produces a torque k, resulting in rotational motion. As the motor torque is proportional to the applied current I, the steady state operation of the motor is described by

$$Vb = \omega \cdot k = Vm - I \cdot Rm \qquad (1)$$

where Vb represents the potential drop converted into rotational motion. To obtain a slow motor rotation $\omega$, *Vb* has to be small, as illustrated in Figure 7(a). Therefore, according to (1) the motor needs high current to operate effectively. The substrate holder may also be tilted at a desired angle during the deposition process. The adjustable tilted platform 20 is illustrated in Figure 6(c).

A circuit which accomplishes there requirements (low *Vb* and high I) is illustrated in Figure 7(b). The voltage supplied by the source Vs is stabilised and reduced through Zener diodes Z1, Z2 and resistances R1, R2. Transistor T1 is connected in common collector configuration to amplify the current at the output. Potentiometer RP1 allows the fine tuning of the voltage applied to the motor Vm.

This simple electronic circuit provides a smooth and stable rotational speed required to create high-quality sculptured 3D nano-structures. The system can be readily manufactured at low cost and can be retrofitted in a general purpose evaporator. Furthermore, the system is fully portable as it does not need an external power supply when fitted to an evaporator. The system is powered by an internal battery. Therefore, the evaporator does not require any modifications to encompass the system.

In the specification the terms "comprise, comprises, comprised and comprising" or any variation thereof and the terms "include, includes, included and including" or any variation thereof are considered to be totally interchangeable and they should all be afforded the widest possible interpretation and vice versa.

The invention is not limited to the embodiments hereinbefore described but may be varied in both construction and detail.

## Claims

1. A method of growing 3D sculptured nano-structures of high mobility material on a substrate comprising the steps of:

   depositing a layer of high thermal conductive material on a substrate; and
   growing nano-structures on the layer of high thermal conductive material, wherein the high thermal conductive material provides a heat dissipating path to allow for growth of sculptured 3D nano-structures.

2. The method of claim 1 further comprising the step of depositing a layer of readily-soluble low thermal conductive material on the layer of high thermal conductive material

3. The method of claim 1 or claim 2 further comprising the step of controlling the deposition of said layer of high thermal conductive material.

4. The method of claim 3 wherein the step of controlling comprises forming a plurality of spaced apart dots of arbitrary material on top of said substrate, before depositing said layer of high thermal conductive material, or forming a plurality of spaced apart dots of high thermal conductive material on top of the said layer of high thermal conductive material after its deposition on said substrate.

5. The method of any preceding claim wherein the high thermal conductive material is selected from the group of high thermal conductive materials comprising silver, gold, copper, diamond, graphene or related materials with a thermal conductance of $\kappa > 10$ Wm$^{-1}$K$^{-1}$.

6. The method of any preceding claims where the layer of low thermal conductive material is selected from the group of lithographical resist with a thermal conductance of $\kappa < 1$ Wm$^{-1}$K$^{-1}$ such as poly(methyl methacrylate).

7. The method of any of claims 4 to 6 wherein the dots have a height of between 10nm to 100nm.

8. The method of any of claims 4 to 7 wherein the dots have a diameter of between 10nm and 100nm.

9. The method any of claims 4 to 8 wherein the dots have a pitch of between 5$\mu$m and 10nm.

10. The method of any preceding claim wherein said sculptured 3D nano-structures are grown without any additional external cooling or heating.

11. The method of any preceding claim wherein said nano-structures have the form of a squared or circular coil, a chevron, or a slanted or vertical rod.

12. The method of any preceding claim wherein the substrate comprises silicon and any type of dielectrics such as $SiO_2$, MgO, $Si_3N_4$, or AlTiC.

13. The method of any preceding claim wherein said nano-structures can be deliberately positioned on a desired area of arbitrary substrates.

14. A device comprising sculptured nano-structures grown according to the method of any one of claims 1 to 13, and/or the device is selected from the group comprising sensors, nano-inductors, high efficiency energy harvesting devices, magnetic storage devices, nano-bit magnetic recording, chiral materials for electronic and optical applications, chiral sensors, photonic crystals, meta-materials applications, micro- and nano-electromechanical systems and micro- and nano-electrochemical systems.

15. A system adapted for growing sculptured nano-structures on a substrate, the system comprising:

a rotating substrate holder;
at least one motor;
at least one electronic circuit adapted to provide arbitrary rotational speeds; and
a tilted angle control;
**characterised in that** the motor is a continuous direct current motor which provides a continuous and smooth substrate rotation.

Figure 1

Figure 2

(d)

(e)

Figure 2

Figure 3

200 nm     2.00 kV     InLens     12 May 2010

WD = 3.0 mm     File Name = Helices_Aglayer_08.tif

CRANN

Figure 4

**Figure 5**

Figure 6

$$Vb = K*rpm = Vm - I*Rm$$

a)

b)

**Figure 7**

Europäisches
Patentamt

European
Patent Office

Office européen
des brevets

# EUROPEAN SEARCH REPORT

Application Number

EP 11 16 1233

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | US 2010/147371 A1 (CHO SUNG NAE [KR]) 17 June 2010 (2010-06-17) * abstract * * figure 14 * | 1 | INV. B81C1/00 |
| X | US 2010/295635 A1 (SCHUBERT EVA [US] ET AL) 25 November 2010 (2010-11-25) * abstract * * paragraphs [0004], [0025], [0026] * * figure 2 * | 1,3,5, 7-14 | |
| X | US 2005/006754 A1 (ARIK MEHMET [US] ET AL) 13 January 2005 (2005-01-13) * abstract * * figures 1,2 * * paragraph [0018] - paragraph [0031] * * paragraph [0038] - paragraph [0041] * | 1,3-5, 7-14 | |
| X | US 2007/051970 A1 (JANG JAE-EUN [KR] ET AL) 8 March 2007 (2007-03-08) * abstract * * paragraphs [0003], [0013] * * paragraph [0045] - paragraph [0048] * * figures 7,8 * | 1-9, 11-13 | TECHNICAL FIELDS SEARCHED (IPC) B81C |

The present search report has been drawn up for all claims

| Place of search | Date of completion of the search | Examiner |
|---|---|---|
| Berlin | 22 September 2011 | Guidoin, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

Application Number

EP 11 16 1233

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-14

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 11 16 1233

The Search Division considers that the present European patent application does not comply with the requirements of unity of invention and relates to several inventions or groups of inventions, namely:

    1. claims: 1-14

        A device comprising nano-structures
               ---

    2. claim: 15

        A system adapted for growing nano-structures
               ---

**ANNEX TO THE EUROPEAN SEARCH REPORT
ON EUROPEAN PATENT APPLICATION NO.**

EP 11 16 1233

This annex lists the patent family members relating to the patent documents cited in the above-mentioned European search report.
The members are as contained in the European Patent Office EDP file on
The European Patent Office is in no way liable for these particulars which are merely given for the purpose of information.

22-09-2011

| Patent document cited in search report | | Publication date | Patent family member(s) | | Publication date |
|---|---|---|---|---|---|
| US 2010147371 | A1 | 17-06-2010 | KR<br>KR<br>US | 20100021336 A<br>20100021350 A<br>2010147371 A1 | 24-02-2010<br>24-02-2010<br>17-06-2010 |
| US 2010295635 | A1 | 25-11-2010 | NONE | | |
| US 2005006754 | A1 | 13-01-2005 | EP<br>JP<br>JP<br>US<br>WO | 1642333 A2<br>4754483 B2<br>2007531243 A<br>2005006754 A1<br>2005031860 A2 | 05-04-2006<br>24-08-2011<br>01-11-2007<br>13-01-2005<br>07-04-2005 |
| US 2007051970 | A1 | 08-03-2007 | KR<br>US | 20070027233 A<br>2007051970 A1 | 09-03-2007<br>08-03-2007 |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100147371 A

**Non-patent literature cited in the description**

- **ELIAS et al.** Fabrication of Helically Perforated Gold, Nickel, and Polystyrene Thin Films. *Journal of Micro-electromechanical Systems,* 2004, vol. 13 (5), 808-813